# EUROPEAN PATENT SPECIFICATION

(11) **EP 0 232 106 B1**
(45) Date of publication and mention of the grant of the patent: **24.03.1993**
(21) Application number: 87300670.4
(22) Date of filing: 27.01.1987
(51) Int. Cl.: G03F 7/26

(54) **Plate processing apparatus**
Druckplatten-Behandlungsmaschine
Appareil pour le traitement d'une plaque lithographique

(30) Priority: 30.01.1986 GB 8602274
(43) Date of publication of application: 12.08.1987
(73) Proprietor: Printing Techniques Limited, Brackmills, Northampton, NN4 OPL (GB)
(72) Inventor: Printing Techniques Limited, Brackmills, Northampton, NN4 OPL (GB)
(74) Representative: Wain, Christopher Paul

(56) References cited:
- DE-A- 2 326 122
- US-A- 2 555 874
- US-A- 3 983 758

## Description

The present invention relates to an apparatus for processing lithographic plates.

It is known to process lithographic plates by passing them through an apparatus where they are treated firstly with developer solution, then rinsed, then treated with gumming solution and finally they are air dried. In such apparatus, the plate passes through a series of rollers from treatment stage to treatment stage. The various liquids used to treat the plate are kept in tanks below the treatment zones and the drive to the rollers passes through the walls of such tanks.

It is also known to provide a brush for scrubbing the plates during the development treatment. Usually, this rotates above and/or below the plate either at a speed different from that of the plate's movement or in an opposite direction. Again, it is usual for the drive to the rotating brush to be taken through the side wall of the tank.

Lithographic plates may be either positive or negative and different chemicals may be required for developing these different types of plate. The different treatments are generally referred to as alkaline, solvent or acidic chemistry. In a machine for processing plates, it is often necessary to change between one chemistry and another, which process entails washing down the apparatus, including the rollers and brushes. With apparatus as described above, this can be difficult since it is not easy to remove the rollers nor brushes and thereby obtain access to the interior of the tanks below.

It is an object of the present invention to provide an apparatus where the moving parts may be easily removed for cleaning during changeover or whenever desired and which can therefore be adapted easily for use with various chemistries.

DE-A-2326122 discloses a plate processing apparatus comprising a plurality of tanks, means to transfer liquid contained therein to a treatment zone above the tank for subsequent draining into the tank, and pairs of rollers to transport a plate through the various treatment zones. According to the present invention, such an apparatus is characterised in that there is provided a brush means located in a developer treatment zone and adapted to reciprocate substantially horizontally and transversely to the direction of passage of the plate, to be driven by the same drive shaft as drives at least one of each pair of rollers, and wherein the drive shaft extends through an upper part of each of the tanks, above the usual liquid level therein, and engages operatively the lower of each pair of rollers.

Advantageously the drive shaft is connected to a cam device for producing a reciprocatory motion thereof and the brush means is adapted to be connected to the cam device for movement therewith in an easily disengageable manner, e.g. by pins and sockets.

An embodiment of the present invention will now be more particularly described by way of example and with reference to the accompanying drawings, in which:

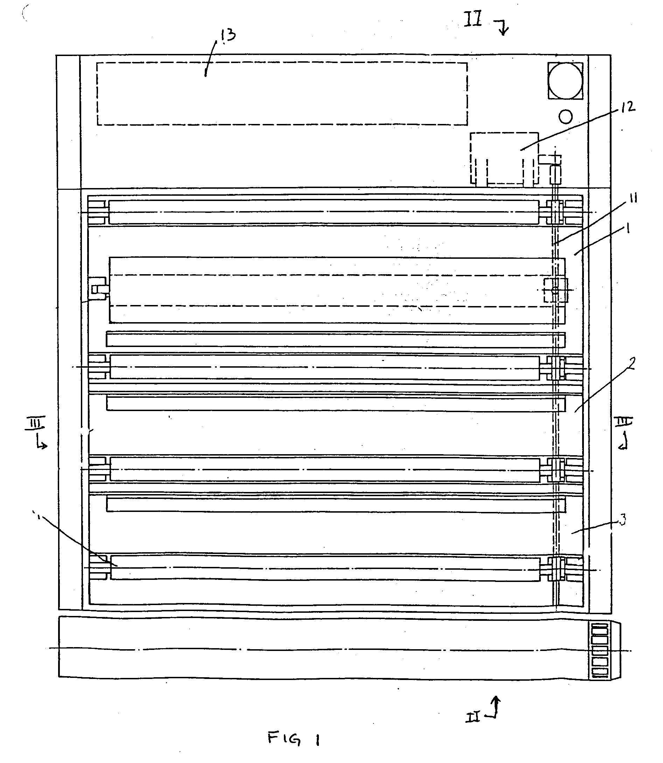

FIGURE 1 is a plan view of an apparatus embodying the invention;
FIGURE 2 is a cross-section along the line II-II of Figure 1;

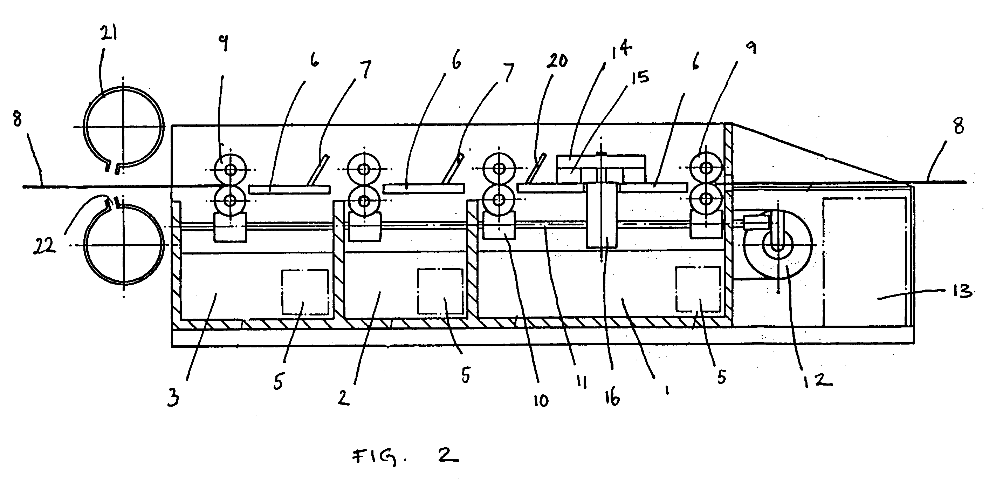

FIGURE 3 is a cross-section taken along the line III-III of Figure 1;
FIGURE 4 is a scrap view of a cam device for producing reciprocatory motion of brush means; and
FIGURE 5 is a similar scrap view of a cam device for double brushes.

Referring now to the drawings, the apparatus comprises three tanks, a first one 1 for developer, a second 2 for water and a third 3 for gumming solution. Each can be drained within a very short time by means of a respective tap 4. Each tank is provided with a pump 5 to transfer the respective liquid to a flood-plate 6 above the tank for use in processing a plate, after which the liquid drains down into its own tank. Squeegee blades 7 are provided to prevent intermixing of the liquids.

A plate, shown schematically as 8 is passed into the apparatus at the right hand end (as shown in Figure 2) and driven over the flood-plate 6 by means of pairs of rollers 9. The rollers are provided at one end with intermeshing gear wheels and the lower of the pair is driven by a worm 10 rotating on a drive shaft 11. The rollers 9 are mounted simply by dropping into locating slots so that they can be removed easily for changeover of chemicals.

The drive shaft 11 extends through an upper part of the walls of all three tanks, above the usual liquid level so that it is not necessary to have perfect seals. Sealing means are provided to prevent liquids splashing through the apertures. The drive shaft 11 is connected to an electric motor 12. The motor 12 runs at a speed to drive the plates through the apparatus at a speed of, e.g. 0.7 metres per minute in the case of a fixed speed drive. Electric control means 13 are provided to vary the speed if so desired so that speed between 1-4 metres per minute can be chosen.

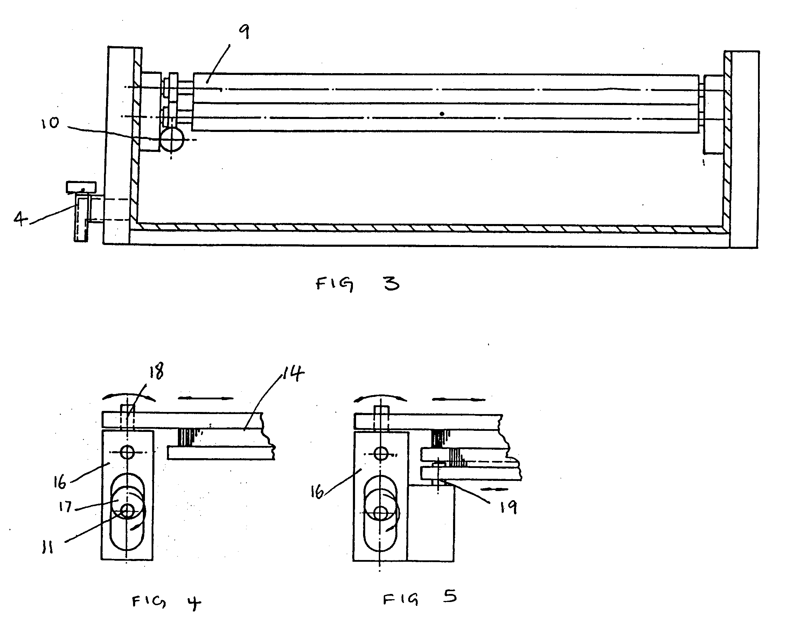

In the developer section, it has been found advantageous to scrub the plate while it is being treated and for this purpose a reciprocating brush arrangement 14 is provided. Preferably, the arrangement comprises two brushes 15 each 25 mm wide and spaced one from the other by a distance slightly greater than that. In the case of double-sided plates a second brush arrangement is provided to act on the lower side of the plate. The brush arrangement is adapted to reciprocate by 20 mm in each direction by means of a cam 17 mounted eccentrically to the drive shaft 11. The cam 17 rotates within a plate 16 which has an aperture of the same width of that of the cam 17 to be reciprocated thereby. The motion of the plate 16 is transferred to the brush arrangement 14 by a simple pin and socket mounting 18. This is shown more clearly in Figure 4, while Figure 5 shows a similar arrangement for use as a double-brush arrangement. In this latter case, the lower brush is mounted on a second pin and socket connection 19 attached to one side of the plate 16. As can be seen, the or each brush can be easily lifted out for cleaning purposes. An additional squeegee blade 20 is provided at one end of the developer section to improve efficiency.

The final step of the process is hot air drying and this is achieved at the left-hand end (as seen in Figure 2) of the apparatus by means of a pair of tubes 21 each having an elongate slit 22 directed towards the plates to be dried. Hot air may be supplied to the tubes by a convenient means.

When it is required to change chemicals, the tanks may be emptied by their respective taps 4 and access to the empty tanks is obtained by lifting out rollers 9, brush assembly 14 and flood-plates 6. This may be accomplished in matter of moments allowing very quick changeover times. Other advantages of the present apparatus are that the drive shaft 11 is inboard of the tanks whereby the machine is more compact and less seals are required since the rollers do not pass through the wall of a tank.

## Claims

1. A plate processing apparatus comprising a plurality of tanks (1-3), means (5) to transfer liquid contained therein to a treatment zone (6) above the tank for subsequent draining into the tank, pairs of rollers (9) to transport a plate through the various treatment zones, characterised in that there is provided a brush means (14) located in a developer treatment zone and adapted to reciprocate substantially horizontally and transversely to the direction of passage of the plate, to be driven by the same drive shaft (11) as drives at least one of each pair of rollers, and wherein the drive shaft (11) extends through an upper part of each of the tanks, above the usual liquid level therein, and engages operatively the lower of each pair of rollers (9).

2. Apparatus as claimed in claim 1, characterised in that the drive shaft (11) is connected to a cam device (17) for producing a reciprocatory motion thereof and the brush means (14) is adapted to be connected to the cam device (17) for movement therewith in an easily disengageable manner, for example by pins and sockets.

## Patentansprüche

1. Druckplatten-Behandlungsmaschine mit mehreren Behältern (1-3), einer Einrichtung (5) zum Befördern der darin enthaltenen Flüssigkeit in eine Behandlungszone (6) oberhalb des Behälters zum nachfolgenden Ablaufen in den Behälter, mit Paaren von Walzen (9), um eine Druckplatte durch die verschiedenen Behandlungszonen zu transportieren,
**dadurch gekennzeichnet,**
daß eine Bürsteneinrichtung (14) in einer Entwicklungsbehandlungszone angeordnet ist und im wesentlichen horizontal und quer zur Durchgangsrichtung der Druckplatte hin- und herbewegbar ist, wobei sie von derselben Antriebswelle (11) angetrieben wird, die wenigstens eine Walze von jedem Paar von Walzen antreibt, und daß die Antriebswelle (11) sich durch den oberen Teil jedes Behälters erstreckt, oberhalb des jeweiligen Flüssigkeitsspiegels, und antriebsmäßig mit der unteren jedes Paares von Walzen (9) verbunden ist.

2. Maschine nach Anspruch 1,
dadurch gekennzeichnet, daß die Antriebswelle (11) mit einer Nockeneinrichtung (17) verbunden ist, um eine wechselseitige Bewegung bei dieser zu erzeugen, und daß die Bürsteneinrichtung (14) mit der Nockeneinrichtung (17) zur Bewegung mit dieser auf leicht trennbare Weise, beispielsweise durch Stifte und Hülsen, verbindbar ist.

## Revendications

1. Un appareil de traitement de plaque comportant plusieurs réservoirs (1-3), un moyen (5) pour transférer le liquide contenu dans ceux-ci vers une zone de traitement (6) au-dessus du réservoir pour son écoulement subséquent dans le réservoir, des paires de rouleaux (9) pour transporter une plaque à travers les différentes zones de traitement, caractérisé en ce qu'un agencement de brosses (14) est ménagé qui se trouve dans une zone de traitement par révélateur et qui est adapté pour avoir un mouvement de va-et-vient substantiellement horizontalement et transversalement à la direction du passage de la plaque, pour être entraîné par le même arbre menant (11) que celui qui entraîne au moins une paire de rouleaux, et dans lequel l'arbre menant (11) s'étend à travers la partie supérieure de chacun des réservoirs, au-dessus du niveau habituel du liquide ci-dedans, et engage opérativement la partie inférieure de chaque paire de rouleaux (9).

2. Appareil selon la spécification 1, caractérisé en ce que l'arbre menant (11) est raccordé à un dispositif à came (17) pour produire un mouvement alternatif de celui-ci et le moyen à brosses (14) est adapté pour être raccordé au dispositif à came (17) pour le mouvement avec celui-ci de manière facilement désengageable, par des broches et des emboîtements par exemple.
